# EUROPEAN PATENT APPLICATION

(11) **EP 4 456 140 A1**
(43) Date of publication of application: **30.10.2024**
(21) Application number: 23170597.1
(22) Date of filing: 28.04.2023
(51) Int. Cl.: H01L 29/06, H01L 29/16, H01L 29/36, H01L 29/872

(54) **SCHOTTKY BARRIER CONTROL IN VERTICALLY ORIENTED SEMICONDUCTOR DEVICES AS WELL AS A CORRESPONDING POWER DEVICE**

(71) Applicant: Nexperia B.V., 6534 AB Nijmegen (NL)
(72) Inventor: MAZZILLO, Massimo Cataldo, Hamburg (DE); BÖTTCHER, Tim, 22529 Hamburg (DE); EL-ZAMMAR, Georgio, Hamburg (DE)
(74) Representative: Pjanovic, Ilija

(57) **Abstract**

A vertically oriented semiconductor device comprising a semiconductor body, the semiconductor device having a first major surface and comprises a substrate, a first region, for example an epitaxial layer, provided on said substate and having a first conductivity type, said first region having a first doping concentration, a metal layer provided on top of said first region, such that a Schottky junction is provided between said first region and said metal layer, at least two, laterally spaced, islands, extending from said first major surface downward into said semiconductor body, said islands having said second conductivity type, wherein the semiconductor device further comprises a surface layer, provided in between said first region and said metal layer, and provided, laterally, in between said at least two, laterally spaced, islands, wherein said surface layer is of a second conductivity type, opposite to said first conductivity type, said surface layer having a second doping concentration being in a range of 5% - 20% of said first doping concentration.

## Description

### Technical field

The present disclosure is generally related to the field of vertically oriented semiconductor and, more specifically, to vertically oriented semiconductors that have a Schottky junction.

### Background

Due to improved electrical and physical properties of silicon carbide, SiC, material, such as wide bandgap, high critical breakdown electric field, and high thermal conductivity, SiC power devices have great potential for high voltage, highfrequency, and high-temperature applications.

The past two decades have witnessed tremendous progress of the SiC power diode towards commercialization and application with relevant implications in terms of costs, die size and manufacturability issues especially on high voltage devices. The SiC Schottky barrier diode, SBD, was first commercialized due to its low onset voltage and negligible reverse recovery, compared with the p-i-n diode.

However, the large leakage current under high blocking voltage limits its performance and application. The junction barrier Schottky, JBS, diode, trench junction barrier Schottky, TJBS, diode, trench Metal Oxide Semiconductor, MOS, barrier Schottky, TMBS, diode, and dual-metal Schottky diode were developed to address the above problem and to achieve the trade-off between forward voltage drop and reverse leakage current.

However, all these designs are characterized by a significant higher technology complexity with consequent increase of manufacturability issues, lead time and costs. To further improve diodes' characteristics, SiC merged p-i-n Schottky, MPS, diodes were proposed to endure high surge current stress.

Despite the improvements brought by the new designs, all the power diodes including Schottky junctions still show consistent limitations due to high leakage current, especially at high temperature. If not properly controlled, the leakage increase can have a relevant impact on the reverse voltage blocking capability and reliability, resulting in yield loss and premature fails.

In Schottky diodes, a high epilayer doping is required to reduce the voltage drop in forward conduction mode. On the other hand, a high surface epilayer doping can increase the electrical field at the Schottky junction interface and reduce the depleted region width in the semiconductor, leading to a remarkable leakage increase mostly dominated by thermionic field emission. In Schottky diodes, the leakage increases exponentially with high temperatures and low barrier height. Therefore, the control of the epilayer doping on the wafer is of crucial importance to guarantee robust operation in many use cases.

In particular the epilayer doping at the wafer edge is usually higher than in the centre, leading to leakage increase and high yield loss. Therefore, technology improvements are needed to improve the electrical characteristics and increase the wafer yield in diodes including Schottky junctions.

### Summary

It is an object of the present disclosure to provide for a vertically oriented semiconductor device having a Schottky junction, wherein a semiconductor depletion width is better controlled. It is a further object of the present disclosure to provide for a power device comprising such a vertically oriented semiconductor device.

In a first aspect of the present disclosure, there is provided a vertically oriented semiconductor device comprising a semiconductor body, the semiconductor device having a first major surface and comprises:
- a substrate;
- a first region, for example an epitaxial layer, provided on said substate and having a first conductivity type, said first region having a first doping concentration;
- a metal layer provided on top of said first region, such that a Schottky junction is provided between said first region and said metal layer;
- at least two, laterally spaced, islands, extending from said first major surface downward into said semiconductor body, said islands having said second conductivity type;
wherein the semiconductor device further comprises:
- a surface layer, provided in between said first region and said metal layer, and provided, laterally, in between said at least two, laterally spaced, islands, wherein said surface layer is of a second conductivity type, opposite to said first conductivity type, said surface layer having a second doping concentration being in a range of 5% - 20% of said first doping concentration.

The inventors have found that it is beneficial to provide for a surface layer, in between said first region and the metal layer, and provided, laterally, in between said at least two, laterally spaced, islands, as this allows for a better control of the electrical characteristics, especially for the devices manufactured around the rim of the wafer with - thus - potential consistent increase of the wafer yield.

The advantage of using such a surface layer is that it reduces the doping of the first region at the interface with the metal layer, thereby allowing for an overall reduction of the leakage current. This is especially the case for semiconductor devices that are construed from the edge of a wafer where, typically, the doping of the first region is considerably higher.

Due to the lower surface doping, the depleted region formed at the Schottky junction is larger, thereby reducing the tunnelling emission and thus also reducing the overall leakage current under high reverse bias.

In an example, the surface layer does not extend up to any of the two, laterally spaced, islands.

The surface layer is thus located in a central area between contiguous islands. The surface layer does not "reach" the islands itself. One of the advantages hereof is that a more uniform Schottky depleted region width is obtained between the islands.

In further example, wherein a second surface layer is provided in between said surface layer and any of said two, laterally spaced, island, said second surface layer having said first conductivity type.

In the following, it is assumed that the first conductivity is of N-type and that the second conductivity is of P-type. It is explicitly noted that the present disclosure is also applicable to the opposite.

The P-implant, i.e. the surface layer, may be applied only in the central region between adjacent P island, i.e. P wells, in a selective manner. This approach ensures that the width of the Schottky depleted region between P islands remains more consistent. This is due to the fact that the N-doping in the surface region near the P-island implants is compensated by the lateral straggling of the P-implant, which is typical in SiC material.

As a result, the Schottky current will be more uniform both in reverse and forward operating conditions. This will help to reduce the occurrence of hot spots, which can be harmful to the device's lifetime.

In a further example, the second surface layer is provided in between said surface layer and any of said two, laterally spaced, island, said second surface layer having said second conductivity type, and wherein a doping concentration of said second surface layer is lower than a doping concentration of any of said two, laterally spaced, islands and lower than a doping concentration of said surface layer.

As previously noted, the N-doping near the P wells may be partially compensated by the lateral spread of the P-well doping. Consequently, a lower doping P-type implant may be sufficient to counteract the higher N-doping in this region compared to the central area between P-wells.

For P-- and P- implants with depths ranging from 50nm to 200nm, the doping levels may differ slightly. Specifically, the P-- implant may have a doping level between 5% and 10% of the first region, while the P- implant may have a doping level between 10% and 20% of the first region doping, but their depths may be the same. The P-- implant refers to the implant of the second surface layer. The P- implant refers to the implant of the surface layer.

The second surface layer may extend deeper into said semiconductor material than said surface layer, for example by 5% - 50%.

The advantage hereof is that it may be beneficial to better compensate for the N-type dopant in the area closer to the P island.

In a further example, the doping concentration of said surface layer is non-uniform in lateral direction.

For example, a highest doping concentration of said surface layer may be in a lateral middle part of said surface layer, and wherein said doping concentration decreases laterally in a direction towards said at least two islands.
ate

The advantage heroef if that it further increases the Schottky current uniformity in both reverse and forward operating conditions. This example might be beneficial to accomplish a more uniform Schottky depleted region, and thus more uniform Schottky current, in the area between the P islands.

In a further example, the surface layer has said second doping being in a range of 7,5% - 12,5% of said first doping concentration.

In another example, the surface layer has a depth into said semiconductor device, from said first major surface, of between 50nm - 200nm.

In a further example, the first region comprises:
- an epitaxial layer provided on said substrate, and
- an NCS layer provided on top of said epitaxial layer, wherein said NCS layer has said first doping concentration,
and wherein a doping concentration of said epitaxial layer is lower than said first doping concentration.

In a semiconductor device, the epitaxial layer may be a thin layer of semiconductor material that is deposited on top of the substrate using a process called epitaxy. This layer has a carefully controlled thickness and doping concentration, and may be designed to have specific electrical properties that are different from the substrate material.

The epitaxial layer may play a role in the performance of semiconductor devices by providing a platform for the formation of active devices such as transistors and diodes, as well as providing a means for controlling the electrical properties of the device.

NCS means N current spread layer. It is usually implanted and not deposited by epitaxy. It has a slightly higher doping than the epitaxial layer and it is added with the purpose to reduce, at low bias, the depleted region thickness in the area between the P islands, allowing for a reduction of the channel resistance. In other words, allowing more current to flow from the Schottky top anode contact to the bottom cathode and reducing in this way the conduction losses in forward bias.

In a further example, a width of said second surface layer is between 5% - 20% of a lateral spacing between said two islands.

In yet another example, any of said at least two islands comprises:
- an inner island, of said second conductivity type, said inner island being encompassed by said corresponding island, and wherein a doping concentration of said inner island is higher than a doping concentration of said corresponding island.

In an example, the semiconductor device is any of:
- a Merged PIN Schottky diode;
- a Schottky diode.

In a further example, the semiconductor device is a power semiconductor device.

In another example, the first doping concentration of said first region is non-uniform in a lateral direction.
it is noted that at the edge of a wafer, the doping concentration of the semiconductor material can increase. The doping non-uniformity may be caused by growth process inhomogeneity across the wafer which may lead to higher epitaxial doping at the edge.

In addition, the doping profile can be affected by the edge effects of the processing steps used to create the device on the wafer. These edge effects can lead to variations in the doping concentration at the edges of the wafer compared to the center of the wafer. As such, the doping concentration of the first region is non-uniform in a lateral direction indicating that the semiconductor device is construed from the rim of the wafer.

In yet another example, the semiconductor body comprises Silicon Carbide, SiC.

In a further example, the first conductivity is N-type conductivity and wherein the second conductivity is P-type conductivity.

In a second aspect of the present disclosure, there is provided a power device comprising a vertically oriented semiconductor device in accordance with any of the previous examples.

It is noted that the advantages as explained with respect to the first aspect of the present disclosure, being the semiconductor device, are also applicable to the second aspect of the present disclosure, being the power device comprises such a semiconductor device.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1 discloses a Merged PIN Schottky diode in accordance with the present disclosure;
Fig. 2 discloses a further Merged PIN Schottky diode in accordance with the present disclosure;
Fig. 3 discloses another Merged PIN Schottky diode in accordance with the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

The doping uniformity on a wafer, of Silicon Carbide, SiC, epitaxial layers grown by CVD is currently one of the most relevant technology issues for SiC processing, ultimately leading to significant yield loss.

The epilayer doping is typically consistently higher at the wafer's rim, resulting in the need to apply quite large edge exclusions, typically 6 mm, to reject the devices at the periphery usually affected by very high leakage and extremely poor reverse voltage blocking capability.

SiC wafers are extremely expensive and grown on substrates with relatively small diameter, typically 6 inches. As such, 6 mm edge exclusion on 6 inches wafer diameter results in about 15% wafer area loss, with consequent remarkable impact on the production costs.

Despite the application of the 6 mm edge exclusion, there are still some devices at the wafer's edge showing higher leakage and poorer reverse voltage blocking capability, compared to those manufactured in the center. Besides other process non uniformities on the wafer, the higher epilayer doping can be considered the main cause for the not ideal behavior of devices manufactured at the rim.

Here below, a description of a Merged PIN Schottky diode in accordance with the present disclosure is described. A Merged PIN Schottky diode comprises a substrate (not shown) and several other layers that are discussed here below.

First, a N-drift layer is created by epitaxy. The thickness of this layer may vary, as it depends on the breakdown voltage of the desired diode. The doping level can vary from 1e15 cm-3 to 5e16 cm-3.

An NCS layer is provided having a depth ranging from 300nm to 1500nm with a doping between 1e16cm-3 and 5e17cm-3. The layer can be used mainly to have a better spread of the Schottky current into the drift layer.

P-island doped layers are provided with a depth ranging from 200nm to 1200nm with a doping between 1e17cm-3 and 5e18cm-3.

A P+ highly doped layer is provided having a depth ranging from 50nm to 400nm with a doping between 1e19cm-3 and 5e20cm-3. This enrichment layer can be used to reduce the P contact resistance.

A thin surface P- implant is provided, in between the P islands, with doping in the range 5% to 20%, preferably 10%, of the doping of the NCS layer or of the epilayer drift layer, if the NCS layer is not included, and depth in the range 50nm to 200 nm. The shallow low doped P- implant is such not to turn the N doped surface layer, either NCS or epilayer, to p-type conductivity.

A top metal layer, for example Ti or Mo, is used to form an ohmic contact with the P doped layer and Schottky contact with the N doped regions in between. A different metal layer, for example NiSi, can be used on top the P+ regions to minimize the contact resistance.

It is noted that the substrate, top and back side metallization, passivation layers and termination region are not shown in the figure, but a skilled person in the art would acknowledge the presence thereof, in so far required.

The P- surface implant reduces the epilayer/NCS doping at the interface with the Schottky metal allowing for an overall reduction of the leakage current, especially at the wafer edge where the N doping is higher. Due to the lower N surface doping, the depleted region formed at the Schottky junction is larger, reducing the tunnelling emission and thus the overall leakage current under high reverse bias.

This design allows more robust operation, also at high temperatures, where the high thermionic emission combined to the tunnelling contribution to the leakage would produce thermal run-away effects leading to reduced life-time or early failures. Being the tunnelling a threshold process depending on the width of the depleted region, depending in turn on the N epilayer doping and reverse bias, the leakage reduction effect is particularly effective for devices manufactured at the wafer edge where the high epilayer doping leads to the premature triggering of the thermionic field emission.

This leads to an increase of the wafer yield and reduction of wafer area loss, as in principle smaller edge exclusions could be applied and diodes fabricated at the rim would have more robust performance better aligned to target specs.

Furthermore, the P- surface implant is used just to correct the N surface doping, allowing for the use of higher N epilayer/NCS doping in the bulk leading to resistive loss decrease, i.e. voltage drop reduction, in conduction phase.

The P- implant can be defined in the active area of all the diodes manufactured on the wafer, i.e. stepper photolithography. Nonetheless, the P- implant can be used to correct the high N doping only at the wafer edge using mask aligners.

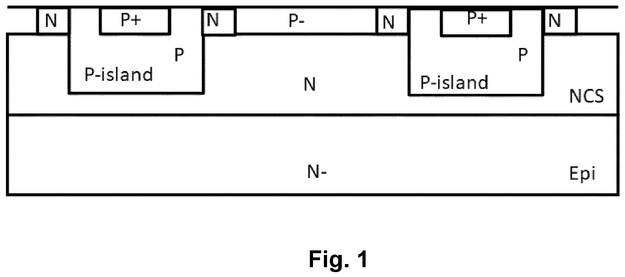

In the example shown in Fig. 1 the P- implant is selectively done only in the central area between contiguous P wells, i.e. P islands. This implementation allows to have a more uniform Schottky depleted region width between P wells, due to the fact the N doping in the surface region close to P wells implants is compensated by the P implant lateral straggling, typical in SiC material.

The overall effect will be a substantial increase of Schottky current uniformity both in reverse and forward operating conditions, leading to a consistent reduction of hot spots detrimental for lifetime. In this embodiment the P- implant is defined at the centre of the area between contiguous P wells with a width ranging from 60% to 90% the width of the Schottky region between the same P wells.

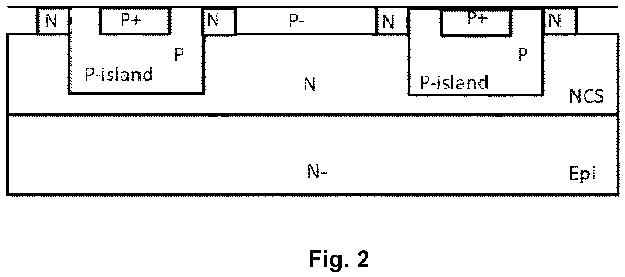

For the same purpose, the further embodiment shown in Fig. 2 is provided, where an additional low doped P-- implant is done only in the region adjacent to the P wells. As reported before, the N doping in the region contiguous to the wells is already partly compensated by the lateral spread of the P well doping.

Hence, in principle a lower doping P-- type implant would be needed to compensate the higher N doping in this region, compared to the central area between P wells. P-- and P- implants can have the same depth in the range 50nm to 200 nm and slightly different doping with the P-- implant with doping between 5% and 10% of the NCS, or of the epilayer, doping and the P- implant with doping between 10% and 20% of the NCS, or of the epilayer, doping.

In this example, the width of the P-- region can range between 5% and 20% of the width of the N doped region between contiguous P wells.

Following the above, the present disclosure, a relatively thin P- layer is used to compensate higher N epilayer/NCS doping at the Schottky interface of diodes including Schottky junctions. This solution allows to reduce the leakage especially on devices manufactured at the wafer edge leading to a consistent improvement of the electrical characteristics, robustness and wafer yield.

This solution is also compatible to the need to use relatively high epilayer doping to reduce the resistive losses during forward conduction.

Additional examples are provided above to improve the Schottky current flow uniformity in the region between contiguous P wells in diode designs including P doped regions, e.g. JBS, MPS.

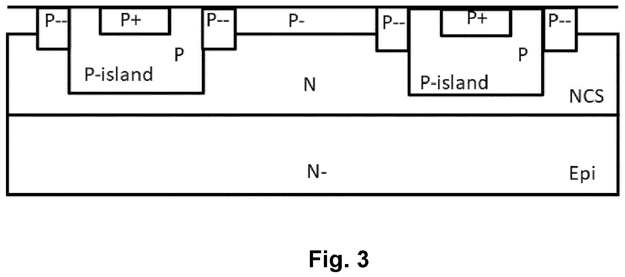

Figure 3 discloses another example of an Merged PIN Schottky diode in accordance with the present disclosure.

Here, the depth of the second surface layer is deeper than that of the surface layer. The lateral straggling affects the P island, implant which is deeper than both the surface implants. The use of a slightly deeper second surface layer might be beneficial to have a better compensation of the N-type dopant in the area closer to the islands.

The depth of the second surface layer may be 5% to 50% deeper than that of the surface layer. To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A vertically oriented semiconductor device comprising a semiconductor body, the semiconductor device having a first major surface and comprises:
- a substrate;
- a first region, for example an epitaxial layer, provided on said substate and having a first conductivity type, said first region having a first doping concentration;
- a metal layer provided on top of said first region, such that a Schottky junction is provided between said first region and said metal layer;
- at least two, laterally spaced, islands, extending from said first major surface downward into said semiconductor body, said islands having said second conductivity type;
wherein the semiconductor device further comprises:
- a surface layer, provided in between said first region and said metal layer, and provided, laterally, in between said at least two, laterally spaced, islands, wherein said surface layer is of a second conductivity type, opposite to said first conductivity type, said surface layer having a second doping concentration being in a range of 5% - 20% of said first doping concentration.

2. A vertically oriented semiconductor device in accordance with claim 1, wherein said surface layer does not extend up to any of the two, laterally spaced, islands.

3. A vertically oriented semiconductor device in accordance with claim 2, wherein a second surface layer is provided in between said surface layer and any of said two, laterally spaced, island, said second surface layer having said second conductivity type, and wherein a doping concentration of said second surface layer is lower than a doping concentration of any of said two, laterally spaced, islands and lower than a doping concentration of said surface layer.

4. A vertically oriented semiconductor device in accordance with claim 3, wherein said second surface layer extends deeper into said semiconductor material than said surface layer.

5. A vertically oriented semiconductor device in accordance with claim 4, wherein said second surface layer extends deeper into said semiconductor material by 5% - 50% than said surface layer.

6. A vertically oriented semiconductor device in accordance with claim 2, wherein a second surface layer is provided in between said surface layer and any of said two, laterally spaced, island, said second surface layer having said first conductivity type.

7. A vertically oriented semiconductor device in accordance with any of the previous claims, wherein a doping concentration of said surface layer is non-uniform in lateral direction.

8. A vertically oriented semiconductor device in accordance with claim 7, wherein a highest doping concentration of said surface layer is in a lateral middle part of said surface layer, and wherein said doping concentration decreases laterally in a direction towards said at least two islands.

9. A vertically oriented semiconductor device in accordance with any of the previous claims, wherein said surface layer has said second doping being in a range of 7,5% - 12,5% of said first doping concentration.

10. A vertically oriented semiconductor device in accordance with any of the previous claims, wherein said surface layer has a depth into said semiconductor device, from said first major surface, of between 50nm - 200nm.

11. A vertically oriented semiconductor device in accordance with any of the previous claims, wherein said first region comprises:
- an epitaxial layer provided on said substrate, and
- an NCS layer provided on top of said epitaxial layer, wherein said NCS layer has said first doping concentration,
and wherein a doping concentration of said epitaxial layer is lower than said first doping concentration.

12. A vertically oriented semiconductor device in accordance with any of the previous claims, wherein a width of said second surface layer is between 5% - 20% of a lateral spacing between said two islands.

13. A vertically oriented semiconductor device in accordance with any of the previous claims, wherein any of said at least two islands comprises:
- an inner island, of said second conductivity type, said inner island being encompassed by said corresponding island, and wherein a doping concentration of said inner island is higher than a doping concentration of said corresponding island.

14. A vertically oriented semiconductor device in accordance with any of the previous claims, wherein said semiconductor device is any of:
- a Merged PIN Schottky diode;
- a Schottky diode.

15. A vertically oriented semiconductor device in accordance with any of the previous claims, wherein said semiconductor device is a power semiconductor device.

16. A vertically oriented semiconductor device in accordance with any of the previous claims, wherein the first doping concentration of said first region is non-uniform in a lateral direction.

17. A vertically oriented semiconductor device in accordance with any of the previous claims, wherein said semiconductor body comprises Silicon Carbide, SiC.

18. A vertically oriented semiconductor body in accordance with any of the previous claims, wherein the first conductivity is N-type conductivity and wherein the second conductivity is P-type conductivity.

19. A power device comprising a vertically oriented semiconductor device in accordance with any of the previous claims.
